# EUROPÄISCHE PATENTSCHRIFT

(11) **EP 1 166 171 B1**
(45) Veröffentlichungstag und Bekanntmachung des Hinweises auf die Patenterteilung: **04.12.2002**
(21) Anmeldenummer: 00931006.1
(22) Anmeldetag: 03.04.2000
(51) Int. Cl.: G02F 1/01

(54) **EINSTELLBARES BRAGG-GITTER-FILTERMODUL**
ADJUSTABLE BRAGG-GRATING FILTER MODULE
MODULE FILTRE A RESEAU DE BRAGG REGLABLE

(30) Priorität: 13.04.1999 DE 19916571
(43) Veröffentlichungstag der Anmeldung: 02.01.2002
(73) Patentinhaber: SIEMENS AKTIENGESELLSCHAFT, 80333 München (DE)
(72) Erfinder: STOLL, Detlef, D-81377 München (DE); LEISCHING, Patrick, D-80802 München (DE); BOCK, Harald, D-86150 Augsburg (DE); RICHTER, Alexander, D-81475 München (DE)
(86) Internationale Anmeldenummer: DE0001026
(87) Internationale Veröffentlichungsnummer: WO00062118

(56) Entgegenhaltungen:
- US-A- 5 673 129
- US-A- 5 694 503
- KIM S Y ET AL: "CHANNEL-SWITCHING ACTIVE ADD/DROP MULTIPLEXER WITH TUNABLE GRATINGS" 8. Januar 1998 (1998-01-08) , ELECTRONICS LETTERS,GB,IEE STEVENAGE, VOL. 34, NR. 1, PAGE(S) 104-105 XP000773635 ISSN: 0013-5194 in der Anmeldung erwähnt das ganze Dokument

## Beschreibung

Die Erfindung betrifft ein elektronisch einstellbares Bragg-Filtermodul.

In optischen Netzen wird in zunehmendem Maße zur Übertragung die Wellenlängen-Multiplextechnik eingesetzt, bei der mehrere Übertragungskanäle mit unterschiedlichen Wellenlängen verwendet werden. Um Verbindungen zwischen einzelnen Terminals flexibel schalten zu können, man spricht vom flexiblen Routing von Wellenlängenkanälen, werden Add-Drop-Module verwendet, die das Auskoppeln (Drop) und Einkoppeln (Add) einzelner Kanäle oder Kanalgruppen ermöglichen. Diese Add-Drop-Module können als Abzweig- und Einkoppelelemente enthalten abstimmbare Faser-Bragg-Gitter enthalten, die als Filter wirken und kurz als Bragg-Filter bezeichnet werden.

In Electronics Letters, 8 January 1998, Vol. 34, No. 1, Seite 104 und 105 sind solche Add-Drop-Elemente beschrieben. Die Zentralfrequenz (hier Sperrfrequenz) der als Gratings (Gitter) ausgebildeten Filter kann durch Steuersignale geändert werden. Die Merkmale des oberbegriffs von Anspruch 1 sind aus diesem Dokument bekannt.

Aus dem Patent US 5,673,129 sind ebenfalls Bragg-Gitter bekannt, deren Wellenlänge durch mechanische Spannung einstellbar sind. Die Wellenlänge wird gemessen und durch eine Regelung konstant gehalten. Diese Lösung ist sehr aufwendig und daher für kostengünstige Netze nicht einsetzbar.

Electronics Letters, Bd. 34, Nr.1, Seiten 104 - 105 offenbart ein elektronisch einstellbares Filtermodul. Die "fibre stretcher" bestimmen über Steuersignale die Filterfrequenzen. Die Einstellung erfolgt anscheinend entsprechend vorgegebenen Wertetabellen ohne Frequenzmessung und ist deshalb kostengünstiger aber in der Genauigkeit beschränkt.

Bei der Verwendung von piezoelektrischen Aktoren (Translatoren) ist deren Ausdehnung eine nichtlineare Funktion der angelegten Spannung. Außerdem weisen piezoelektrische Elemente in ihrer Ausdehnungsfunktion ein Hystereseverhalten auf. Die Ausdehungsfunktion ist außerdem temperaturabhängig. Eine genaue Einstellung wird außerdem durch eine mechanische Driftbewegung der Elemente erschwert. Nach einer Veränderung der angelegten Spannung ändert sich die Ausdehnung des Piezoelements trotz konstanter Spannung weiter. Die Zentralfrequenz eines so angesteuerten Bragg-Filters ist hierdurch nicht ausreichend kontrollierbar. Das Hystereseverhalten verhindert eine genaue Reproduzierbarkeit der Einstellung (Fehler zwischen 5 und 10 GHz (Gigahertz)). Die Driftbewegung führt zu einer Ungenauigkeit von etwa 3 GHz. Diese Toleranzen sind bei WDM-Systemen (Wellenlängenmultiplex) schwer verkraftbar.

Aufgabe der Erfindung ist es daher, ein elektronisch einstellbares Bragg-Filtermodul anzugeben, das ohne aufwendige Frequenzmessung eine wesentlich genauere Einstellung der Zentralfrequenz ermöglicht. Weiter sind mit diesem Filter aufgebaute Add-Drop-Module und eine geeignete Einstelleinrichtung zur Einstellung der Filterfrequenz anzugeben.

Ein elektronisch einstellbares Bragg-Filtermodul ist in Anspruch 1 angegeben; ein entsprechendes Add-Drop-Modul und eine Einstelleinrichtung sind in abhängigen Ansprüchen beschrieben.

Mit dem angegebenen Filtermodul ist eine sehr genaue Messung der Längenänderung des Fasergitters möglich, die das Einstellen der zentralfrequenz nach einer einmaligen Eichung des Aufbaus mit etwa 1 GHz Genauigkeit ermöglicht.

Besonders vorteilhaft ist eine Ausführungsform des Filtermoduls, dessen Piezoaktor aus mehreren zusammengefügten Piezoelementen besteht, mit denen ein Faser-Bragg-Gitter fest verklebt ist.

Die entsprechenden Filter können in allen Add-Drop-Modulen verwendet werden. Die Einstellung der Filter erfolgt mit Hilfe eines Regelkreises, dem als Regelgröße ein der Längenveränderung entsprechendes Signal und als Führungsgröße (Sollwert) die gewünschte Längenänderung zugeführt wird, wobei diese entsprechend der Temperaturabhängigkeit der Längenmesseinrichtung und des Bragg-Gitters veränderbar sein kann. Aus Kostengründen wird als Längenmeßeinrichtung ein bekannter Dehnungsmeßstreifen eingesetzt, dessen Widerstand sich mit der Länge ändert. Bei höheren Anforderungen kann ein kapazitiv wirkender Dehnungsmeßsensor eingesetzt werden.

Ein Ausführungsbeispiel der Erfindung wird anhand von Figuren näher erläutert.

Es zeigen:
- Figur 1: ein erfindungsgemäßes Filtermodul,
- Figur 2: ein mit diesem Filtermodul aufgebautes Add-Drop-Modul und
- Figur 3: eine Ansteuereinrichtung für dieses Add-Drop-Modul.

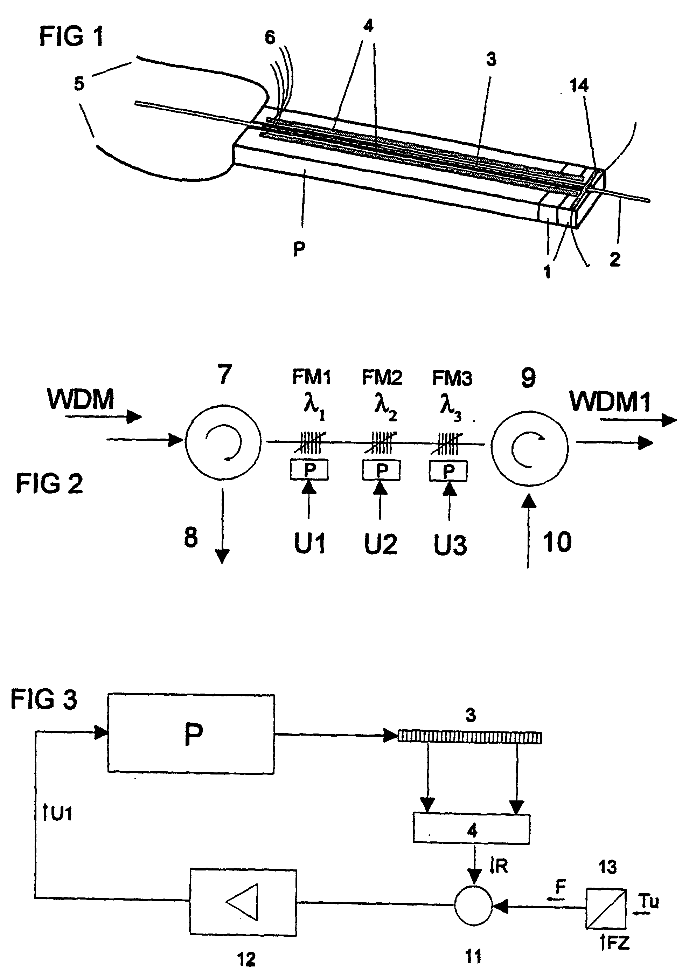

**Figur 1** zeigt ein Ausführungsbeispiel eines abstimmbaren Bragg-Filtermoduls FM. Zur Abstimmung des Filters ist ein aus mehreren aneinandergereihten Piezoelementen 1 aufgebauter Piezoaktor P vorgesehen. Die Ansteuerung erfolgt über elektrische Anschlußleitungen 5. Durch Anlegen unterschiedlicher Spannungen wird eine Längenänderung des Piezoaktors erreicht. In einer auf der Oberfläche angebrachten Nut ist eine optische Faser 2 mit einem Faser-Bragg-Gitter 3 eingeklebt. Dieses wird durch eine spezielle Behandlung der Faser hergestellt, die in definierten Abständen optisch dichter ist, so daß aufgrund von Interferenzvorgängen eine bestimmte Wellenlänge (genauer ein bestimmter Bereich) reflektiert wird. Die geeignetsten Dehnungseigenschaften besitzen derzeit Faser-Gitter, prinzipiell können auch andere z.B. planar ausgeführte Bragg-Gitter verwendet werden.

Über der Faser ist als Längenmeßeinrichtung mindestens ein Dehnungsmeßstreifen 4 angeordnet, dessen Meßanschlußleitungen 6 mit einer Meßeinrichtung verbunden werden. Zur Temperaturkompensation können mehrere Dehnungsmeßstreifen in einer Brückenschaltung angeordnet werden. Je nach Anforderungen können Dehnungsmeßsensor verwendet werden, deren Widerstand oder Kapazität von der Längenänderung abhängig ist. Entsprechend einer Tabelle wird die Länge des Piezoaktors und damit des Bragg-Filters geändert und so eine gewünschte Zentralfrequenz (oder Grenzfrequenz) eingestellt.

Ein weiterer Dehnungsmeßstreifen 14 ist zur Temperaturkompensation vorgesehen.

In **Figur 2** ist ein Add-Drop-Modul dargestellt, das aus der Reihenschaltung eines ersten Zirkulators 7, dreier Filtermodule FM1, FM2, EM3 und einem zweiten Zirkulator 9 besteht. Einem ersten Anschluß des ersten Zirkulators wird ein Wellenlängen-Multiplexsignal WDM zugeführt. Dieses Signal wird an einem zweiten Anschluß (im Uhrzeigersinn) abgegeben, wobei einzelne Kanäle durch die Bragg-Filter der einzelnen Filtermodule FM1 bis EM3 reflektiert und in denselben Anschluß erneut eingespeist werden, um am dritten Anschluß des Zirkulators als Drop-Kanäle 8 ausgegeben zu werden. Über Steuerspannungen U1 bis U3 werden die Piezoaktoren P angesteuert, um die entsprechende Zentralfrequenz-Einstellung der Bragg-Filter durchzuführen. Add-Kanäle 10, die dieselben Wellenlängen aufweisen, werden über eine Einfügeeinrichtung, einen zweiten Zirkulator 9 (oder einen Richtkoppler), eingespeist und zusammen mit den durchgeschalteten Kanälen als Wellenlängen-Multiplexsignal WDM1 ausgesendet.

In **Figur 3** ist ein Regelkreis zur Einstellung des Bragg-Filters 3 dargestellt. Die Zentralfrequenz wird mit Hilfe eines Sollwertgebers 13 eingestellt, dem die Sollfrequenz FZ zugeführt wird. Dieser setzt die Sollfrequenz aufgrund einer gespeicherten Tabelle in eine elektrische Führungsgröße F um, wobei die Umgebungstemperatur Tu berücksichtigt werden kann. In einem Komparator 11 wird eine Regelgröße R mit der Führungsgröße F vergleichen. Die Regelgröße, eine elektrische Spannung, wird mit Hilfe des Dehnungsmeßstreifens 4 gewonnen und dient als Maß für die Länge bzw. Längenänderung des Bragg-Filters 3. In einem Regler 12 wird entsprechende den Abweichungen zwischen Führungs- und Regelgröße eine Einstellspannung U1 gewonnen, die den Piezoaktor P steuert und damit die Länge des Bragg-Filters festlegt. Nichtlinearitäten im Regelkreis werden durch den Sollwertgeber berücksichtigt.

Mit einem herkömmlichen Dehnungsmeßstreifen ist eine Genauigkeit von 1 GHz erzielbar; genauere Längenmessungen können mit kapazitiven Dehnungsmeßstreifen erzielt werden.

## Patentansprüche

1. Bragg-Filtermodul (FM) mit einstellbarer Filterfrequenz, der ein Bragg-Filter (3) und einen elektronischen Aktor (P) zur Einstellung der Länge des Bragg-Filters (3) enthält,
**dadurch gekennzeichnet,**
**daß** zur Messung der Länge oder Längenänderung des Bragg-Filters (3) eine Längenmeßeinrichtung (4) vorgesehen ist.

2. Bragg-Filtermodul (FM) nach Anspruch 1,
**dadurch gekennzeichnet,**
**daß** als Längenmeßeinrichtung (4) mindestens ein Dehnungsmeßstreifen vorgesehen ist.

3. Bragg-Filtermodul (FM) nach Anspruch 2,
**dadurch gekennzeichnet,**
**daß** ein Dehnungsmeßstreifen (4) vorgesehen ist, dessen Widerstand von der Längenänderung abhängig ist.

4. Bragg-Filtermodul (FM) nach Anspruch 3,
**dadurch gekennzeichnet,**
**daß** ein weiterer Dehnungsmeßstreifen (14) zur Temperaturkompensation vorgesehen ist.

5. Bragg-Filtermodul (FM) nach Anspruch 2,
**dadurch gekennzeichnet,**
**daß** als Längenmeßeinrichtung (4) ein Dehnungsmeßsensor vorgesehen ist, dessen Kapazität von der Längenänderung abhängig ist.

6. Bragg-Filtermodul (FM) nach einem der vorhergehenden Ansprüche,
**dadurch gekennzeichnet,**
**daß** zur Längenänderung ein Piezoaktor (P) vorgesehen ist, der aus mehreren Piezoelementen (12) zusammengefügt ist,
**daß** das Bragg-Filter (3) mit dem Piezoaktor (1) fest verbunden ist und
**daß** mindestens ein Dehnungsmeßstreifen (4) mit dem Piezoaktor (1) und/oder dem Bragg-Filter (3) fest verbunden ist.

7. Bragg-Filtermodul (FM) nach Anspruch 6,
**dadurch gekennzeichnet,**
**daß** das Bragg-Filter (3) als Faser-Gitter realisiert ist.

8. Bragg-Filtermodul (FM) nach Anspruch 7,
**dadurch gekennzeichnet,**
**daß** das Faser-Gitter in eine Nut des Piezoaktors (P) eingeklebt ist.

9. Add-Drop-Modul (ADM) enthaltend eine Reihenschaltung mit mindestens einer Abzweigeeinrichtung (7), mindestens einem Bragg-Filtermodul (FM1, FM2, FM3) nach einem der vorhergehenden Ansprüche und mindestens eine Einfügeeinrichtung (9).

10. Einstelleinrichtung mit einem Bragg-Filtermodul (FM) nach einem der Ansprüche 1-8,
**dadurch gekennzeichnet,**
**daß** eine Regelschaltung (11, 12, P, 3, 4) vorgesehen ist, die die Länge oder Längenänderung des Bragg-Filters (3) entsprechend einer der eingestellten Filterfrequenz entsprechenden Führungsgröße (F) konstant hält.

11. Einstelleinrichtung nach Anspruch 10,
**dadurch gekennzeichnet,**
**daß** die Führungsgröße (F) von der Umgebungstemperatur (Tu) abhängig eingestellt wird.

## Claims

1. Bragg filter module (FM) with an adjustable filter frequency, which includes a Bragg filter (3) and an electronic actuator (P) for adjusting the length of the Bragg filter (3), **characterized in that** in order to measure the length or length change of the Bragg filter (3), a length measuring device (4) is provided.

2. Bragg filter module (FM) according to Claim 1, **characterized in that** the length measuring device (4) provided is at least one strain gauge.

3. Bragg filter module (FM) according to Claim 2, **characterized in that** a strain gauge (4) is provided whose resistance depends on the length change.

4. Bragg filter module (FM) according to Claim 3, **characterized in that** a further strain gauge (14) is provided for the purpose of temperature compensation.

5. Bragg filter module (FM) according to Claim 2, **characterized in that** the length measuring device (4) provided is a strain gauge sensor whose capacitance depends on the length change.

6. Bragg filter module (FM) according to one of the preceding claims, **characterized in that** for the purpose of the length change, a piezoelectric actuator (P) is provided which is put together from a plurality of piezoelectric elements (12), **in that** the Bragg filter (3) is permanently connected to the piezoelectric actuator (1), and **in that** at least one strain gauge (4) is permanently connected to the piezoelectric actuator (1) and/or the Bragg filter (3).

7. Bragg filter module (FM) according to Claim 6, **characterized in that** the Bragg filter (3) is implemented as a fibre grating.

8. Bragg filter module (FM) according to Claim 7, **characterized in that** the fibre grating is adhesively bonded to a groove in the piezoelectric actuator (P).

9. An add-drop module (ADM) containing a series circuit with at least one branching device (7), at least one Bragg filter module (FM1, FM2, FM3) according to one of the preceding claims and at least one insertion device (9).

10. Adjusting device having a Bragg filter module (FM) according to one of Claims 1-8, **characterized in that** a control circuit (11, 12, P, 3, 4) is provided which keeps the length or length change of the Bragg filter (3) constant in accordance with a reference variable (F) corresponding to the adjusted filter frequency.

11. Adjusting device according to Claim 10, **characterized in that** the reference variable (F) is adjusted as a function of the ambient temperature (Tu).

## Revendications

1. Module filtre à réseau de Bragg (FM) avec fréquence de filtre réglable, qui contient un filtre de Bragg (3) et un acteur électronique (P) pour le réglage de la longueur du filtre de Bragg (3),
**caractérisé en ce que**
un dispositif de mesure de longueur (4) est prévu pour la mesure de la longueur ou de la modification de la longueur du filtre de Bragg (3).

2. Module filtre à réseau de Bragg (FM) selon la revendication 1,
**caractérisé en ce que**
au moins une jauge de contrainte est prévue comme dispositif de mesure de longueur (4).

3. Module filtre à réseau de Bragg (FM) selon la revendication 2,
**caractérisé en ce que**
une jauge de contrainte (4) est prévue, dont la résistance dépend de la modification de longueur.

4. Module filtre à réseau de Bragg (FM) selon la revendication 3,
**caractérisé en ce que**
une jauge de contrainte supplémentaire (14) est prévue pour la compensation de température.

5. Module filtre à réseau de Bragg (FM) selon la revendication 2,
**caractérisé en ce que**
un capteur de mesure d'allongement est prévu comme dispositif de mesure de longueur (4), dont la capacité dépend de la modification de longueur.

6. Module filtre à réseau de Bragg (FM) selon l'une des revendications précédentes,
**caractérisé en ce que**
un acteur piézoélectrique (P) est prévu pour la modification de longueur, cet acteur étant constitué de plusieurs éléments piézoélectriques (12),
**en ce que** le filtre de Bragg (3) est raccordé de manière fixe à l'acteur piézoélectrique (1) et
**en ce qu'**au moins une jauge de contrainte (4) est raccordée de manière fixe à l'acteur piézoélectrique (1) et/ou au filtre de Bragg (3).

7. Module filtre à réseau de Bragg (FM) selon la revendication 6,
**caractérisé en ce que**
le filtre de Bragg (3) est réalisé comme grille en fibre.

8. Module filtre à réseau de Bragg (FM) selon la revendication 7,
**caractérisé en ce que**
la grille en fibre est collée dans une rainure de l'acteur piézoélectrique (P).

9. Module Add Drop (ADM) comprenant un circuit en série avec au moins un dispositif de dérivation (7), au moins un module filtre à réseau de Bragg (FM1, FM2, FM3) selon l'une des revendications précédentes, et au moins un dispositif d'insertion (9).

10. Dispositif de réglage, avec un module filtre à réseau de Bragg (FM) selon l'une des revendications 1-8,
**caractérisé en ce que**
un circuit de réglage (11, 12, P, 3, 4) est prévu, qui maintient constante la longueur ou la modification de longueur du filtre de Bragg (3) de manière correspondant à une grandeur de guidage (F) correspondant à la fréquence de filtre réglée.

11. Dispositif de réglage selon la revendication 10,
**caractérisé en ce que**
la grandeur de guidage (F) est réglée en fonction de la température ambiante (Tu).
